# EUROPEAN PATENT SPECIFICATION

(11) **EP 4 123 710 B1**
(45) Date of publication and mention of the grant of the patent: **02.12.2026**
(21) Application number: 20736234.4
(22) Date of filing: 03.04.2020
(51) Int. Cl.: G06V 40/13, H10K 59/12, H10K 59/80

(54) **DISPLAY SUBSTRATE**
ANZEIGESUBSTRAT
SUBSTRAT D'AFFICHAGE

(30) Priority: 18.03.2020 CN 202010190784
(43) Date of publication of application: 25.01.2023
(73) Proprietor: Wuhan China Star Optoelectronics Semiconductor Display Technology Co., Ltd., Wuhan, Hubei 430079 (CN)
(72) Inventor: GAO, Hong, Wuhan Hubei 430079 (CN); KIM, Mugyeom, Wuhan Hubei 430079 (CN)
(74) Representative: Patentanwälte Olbricht Buchhold Keulertz
(86) International application number: PCT/CN2020/083252
(87) International publication number: WO 2021/184438

(56) References cited:
- WO-A1-2019/187729
- CN-A- 103 081 079
- CN-A- 107 870 689
- CN-A- 109 216 423
- CN-A- 109 300 963
- CN-A- 109 685 003
- CN-A- 109 685 003
- CN-A- 109 801 946
- CN-A- 110 286 796
- US-A1- 2020 184 178
- US-A1- 2021 134 896

## Description

### BACKGROUND OF THE INVENTION

### 1. Field of the Invention

The present disclosure relates to the technical field of display devices, and particularly to a display substrate with an under-screen fingerprint recognition function.

### 2. The Related Arts

With development of full-screen technology, power-saving technology and fingerprint on display (FOD) technology have become increasingly popular with consumers. With rapid development of the field of display devices, low-temperature polycrystalline oxide (LTPO) display panels have appeared. A current low-temperature polycrystalline oxide display panel usually comprises a low-temperature polysilicon thin film transistor and an oxide thin-film transistor. The low-temperature polysilicon thin film transistor has no threshold voltage drift and is used as a driving transistor. The oxide thin film transistor has good switching performance and is used as a switching transistor. Furthermore, LTPO technology has been used in watches as power-saving technology for emerging active matrix organic light-emitting diodes (AMOLEDs). The fingerprint on display technology has been applied to mobile phone terminals.

The display panel with fingerprint recognition are known, for example, from CN109801946A, and CN109685003A.

### SUMMARY OF THE INVENTION

The present invention provides a display substrate combining LTPO technology and under-screen fingerprint recognition technology, which can realize an under-screen fingerprint recognition function and a screen power saving function.

The invention is set out in the appended set of claims.

The present invention provides a display substrate combining LTPO technology and under-screen fingerprint recognition technology, in which light emitted by an organic light-emitting layer is reflected by a finger and then sensed by an inductive sensor in an under-screen fingerprint recognition structure to wake up a screen, thereby realizing an induction function of a built-in fingerprint on display. Furthermore, the organic light-emitting layer is not a functional layer in the under-screen fingerprint recognition structure. Therefore, the organic light-emitting layer can be removed from the under-screen fingerprint recognition structure to allow more light reflected by the finger to enter the inductive sensor, thereby greatly improving light-sensing ability. The display substrate manufactured using the LTPO technology can also save screen power.

### BRIEF DESCRIPTION OF THE DRAWINGS

In order to more clearly illustrate technical solutions in embodiments of the present invention, a brief description of accompanying drawings used in description of the embodiments will be given below. Obviously, the accompanying drawings in the following description are merely some embodiments of the present invention. For those skilled in the art, other drawings may be obtained from these accompanying drawings without creative labor.
FIG. 1 is a schematic structural diagram of a display substrate according to an embodiment of the present invention.
FIG. 2 is a schematic structural diagram of another display substrate according to an embodiment of the present invention.
FIG. 3 is a schematic diagram showing relative positions of induction sensors of an under-screen fingerprint recognition structure.

### DETAILED DESCRIPTOIN OF THE PREFERRED EMBODIMENTS

Technical solutions in embodiments of the present disclosure will be clearly and completely described below in conjunction with accompanying drawings in the embodiments of the present disclosure. It is apparent that the described embodiments are merely a part of the embodiments of the present disclosure and not all embodiments. All other embodiments obtained by those skilled in the art based on the embodiments of the present disclosure without creative labor are within the claimed scope of the present disclosure.

In the description of the present disclosure, it should be understood that location or position relationships indicated by terms, such as "center", "longitudinal", "transverse", "length", "width", "thickness", "up", "down", "front", "rear", "left", "right", "vertical", "horizontal", "top", "bottom", "within", "outside", "clockwise", and "counterclockwise" are location or position relationships based on illustration of the accompanying drawings, are merely used for describing the present disclosure and simplifying the description instead of indicating or implying the indicated apparatuses or elements should have specified locations or be constructed and operated according to specified locations, and Thereof, should not be intercepted as limitations to the present disclosure. Furthermore, terms such as "first" and "second" are used merely for description, but shall not be construed as indicating or implying relative importance or implicitly indicating a number of the indicated technical feature. Hence, the feature defined with "first" and "second" may explicitly or implicitly includes one or more such features. In the description of the present disclosure, a term "a plurality of" means "two or more" unless otherwise specifically limited.

In the present disclosure, it should be noted that, unless otherwise explicitly specified or defined, the terms such as "mount", "connect", and "connection" should be interpreted in a broad sense. For example, a connection may be a fixed connection, a detachable connection, or an integral connection. A connection may be a mechanical connection, an electrical connection, or a mutual communication. A connection may be a direct connection or may be an indirect connection by using an intermediate medium. A connection may be an internal connection or an interaction between two elements. It may be appreciated by those of ordinary skill in the art that the specific meanings of the aforementioned terms in the present disclosure can be understood depending on specific situations.

In the present disclosure, unless otherwise specifically specified or limited, a structure in which a first feature is "on" or "under" a second feature may comprise an embodiment in which the first feature directly contacts the second feature, and may also comprise an embodiment in which the first feature and the second feature are not in direct contact with each other, but are contacted via an additional feature formed therebetween. Furthermore, a structure in which a first feature is "on", "above", or "on top of" a second feature may comprise an embodiment in which the first feature is right or obliquely "on", "above", or "on top of" the second feature, or just means that a sea-level elevation of the first feature is greater than a sea-level elevation of the second feature. A structure in which a first feature "under", "below", or "on bottom of" a second feature may include an embodiment in which the first feature is right "beneath," "below," or "on bottom of" the second feature, and may also comprises an embodiment in which the first feature is right or obliquely "under", "below", or "on bottom of" the second feature, or just means that a sea-level elevation of the first feature is less than a sea-level elevation of the second feature.

The following description provides different embodiments or examples illustrating various structures of the present invention. In order to simplify the description of the present disclosure, only components and settings of specific examples are described below. They are only examples and are not intended to limit the present invention. Furthermore, reference numerals and/or letters may be repeated in different examples of the present disclosure. Such repetitions are for simplicity and clarity, which per se do not indicate relations among the discussed embodiments and/or settings. Furthermore, the present disclosure provides various examples of specific processes and materials, but those skilled in the art can be aware of application of other processes and/or use of other materials.

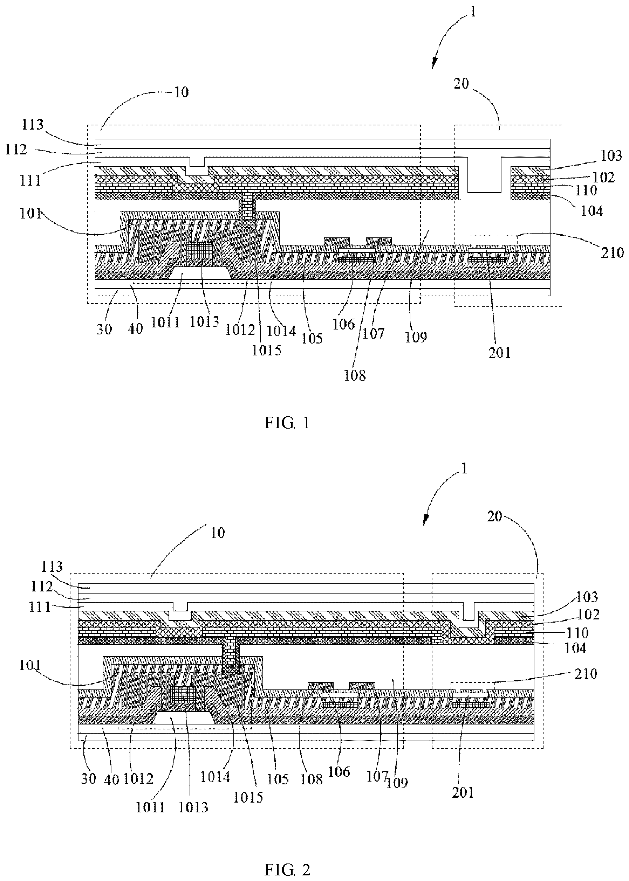

Please refer to FIG. 1, which is a schematic structural diagram of a display substrate 1 according to an embodiment of the present invention. An embodiment of the present invention provides a display substrate 1, comprising:
a display area 10 comprising a low-temperature polycrystalline oxide structure 101, an anode layer 104, an organic light-emitting layer 102, and a cathode layer 103 that are sequentially stacked; and
a fingerprint recognition area 20 comprising an under-screen fingerprint recognition structure 210, wherein the under-screen fingerprint recognition structure 210 is disposed on a same layer as the low-temperature polycrystalline oxide structure 101 and does not comprise the cathode layer 103 and the organic light-emitting layer 102;
wherein, light emitted from the display area 10 is reflected to the under-screen fingerprint recognition structure 210 in the fingerprint recognition area 20 by a fingerprint.

In the display area 10, a flexible substrate 30 is the bottommost layer. An insulating layer 40 is disposed on a side of the flexible substrate 30. The low-temperature polycrystalline oxide structure 101 is disposed on a side of the insulating layer 40 away from the flexible substrate 30. The low-temperature polycrystalline oxide structure 101 is configured as a TFT structure comprising a P-si layer 1011, a first gate insulating layer 1012, a gate electrode layer 1013, a first interlayer dielectric layer 1014, and a first source/drain electrode layer 1015. A second gate insulating layer 105 is disposed on the low-temperature polycrystalline oxide structure 101. A first oxide layer 106 is disposed on the second gate insulating layer 105. A second interlayer dielectric layer 107 is disposed on the first oxide layer 106 and covers the second gate insulating layer 105 and the first oxide layer 106. A second source/drain electrode layer 108 is disposed on the first oxide layer 106 and the second interlayer dielectric layer 107. A flat layer 109 is disposed on the second source/drain electrode layer 108 and covers the second source/drain electrode layer 108 and the second interlayer dielectric layer 107. An anode layer 104 is disposed on the flat layer 109. A pixel defining layer 110 is disposed on the anode layer 104. An organic light-emitting layer 102 is disposed on the pixel defining layer 110. A cathode layer 103 is disposed on the organic light-emitting layer 102. Other layers such as an insulating layer 111 and a polarizer layer 112 are disposed on the cathode layer 103 by a chemical vapor deposition method, an inkjet printing method, and the like. A glass cover 113 is bonded by an adhesive glue to complete packaging.

In the fingerprint recognition area 20, the flexible substrate 30, the insulating layer 40, the first gate insulating layer 1012, and the first interlayer dielectric layer 1014 are sequentially stacked. The gate electrode layer 1013 is disposed on the first interlayer dielectric layer 1014. The second gate insulating layer 105 is disposed on the gate electrode layer 1013 and completely covers the gate electrode layer 1013. A second oxide layer 201 is disposed on the second gate insulating layer 105. The second interlayer dielectric layer 107 is disposed on the second oxide layer 201. The flat layer 109 is disposed on the second interlayer dielectric layer 107. Other layers such as an insulating layer 111 and a polarizer layer 112 are disposed on the flat layer 109 by a chemical vapor deposition method, an inkjet printing method, and the like. A glass cover 113 is bonded by an adhesive glue to complete packaging. The flat layer 109, the second interlayer dielectric layer 107, the second oxide layer 201, the second gate insulating layer 105, and the gate electrode layer 1013 constitute the under-screen fingerprint recognition structure 210.

In this embodiment, as shown in FIG. 1, the under-screen fingerprint recognition structure 210 does not comprise the cathode layer 103 and the organic light-emitting layer 102. The second oxide layer 201 in the under-screen fingerprint recognition structure 210 is a photosensitive element. Therefore, the second oxide layer 201 is used as an inductive sensor of the under-screen fingerprint recognition structure 210. When light emitted by the organic light-emitting layer 102 is reflected to a sensing area of the second oxide layer 201 by a fingerprint on a screen, the screen can be woken up. Since the under-screen fingerprint recognition structure 210 does not comprise the cathode layer 103 and the organic light-emitting layer 102, more light reflected by the fingerprint will enter the sensing area of the second oxide layer 201, thereby improving light-sensing ability and making a fingerprint on display more sensitive.

As shown in FIG. 1, the low-temperature polycrystalline oxide structure 101 and the under-screen fingerprint recognition structure 210 are disposed on a same layer. The anode layer 104 has a characteristic of totally reflecting light, and the cathode layer 103 has a characteristic of semi-reflecting light.

In this embodiment, as shown in FIG. 1, the display substrate 1 comprises the low-temperature polycrystalline oxide structure 101 and the under-screen fingerprint recognition structure 210. The under-screen fingerprint recognition structure 210 does not comprise the organic light-emitting layer 102 and the cathode layer 103. The second oxide layer 201 in the sensing area of the under-screen fingerprint recognition structure 210 is a photosensitive element. After removing the organic light-emitting layer 102 and the cathode layer 103, more light reflected by the fingerprint enters the sensing area of the second oxide layer 201, thereby improving light-sensing ability of the under-screen fingerprint recognition structure 210.

Please refer to FIG. 2, which is a schematic structural diagram of another display substrate according to an embodiment of the present invention. An embodiment of the present invention provides a display substrate 1, comprising:
a display area 10 comprising a low-temperature polycrystalline oxide structure 101, an anode layer 104, an organic light-emitting layer 102, and a cathode layer 103 that are sequentially stacked; and
a fingerprint recognition area 20 comprising an under-screen fingerprint recognition structure 210;
wherein the low-temperature polycrystalline oxide structure 101 and the under-screen fingerprint recognition structure 210 are disposed on a same layer and share the cathode layer 103 and the organic light-emitting layer 102, and light emitted from the display area 10 is reflected to the under-screen fingerprint recognition structure 210 in the fingerprint recognition area 20 by a fingerprint.

In the display area 10, a flexible substrate 30 is the bottommost layer. An insulating layer 40 is disposed on a side of the flexible substrate 30. The low-temperature polycrystalline oxide structure 101 is disposed on a side of the insulating layer 40 away from the flexible substrate 30. The low-temperature polycrystalline oxide structure 101 is configured as a TFT structure comprising a P-si layer 1011, a first gate insulating layer 1012, a gate electrode layer 1013, a first interlayer dielectric layer 1014, and a first source/drain electrode layer 1015. A second gate insulating layer 105 is disposed on the low-temperature polycrystalline oxide structure 101. A first oxide layer 106 is disposed on the second gate insulating layer 105. A second interlayer dielectric layer 107 is disposed on the first oxide layer 106 and covers the second gate insulating layer 105 and the first oxide layer 106. A second source/drain electrode layer 108 is disposed on the first oxide layer 106 and the second interlayer dielectric layer 107. A flat layer 109 is disposed on the second source/drain electrode layer 108 and covers the second source/drain electrode layer 108 and the second interlayer dielectric layer 107. An anode layer 104 is disposed on the flat layer 109. A pixel defining layer 110 is disposed on the anode layer 104. An organic light-emitting layer 102 is disposed on the pixel defining layer 110. A cathode layer 103 is disposed on the organic light-emitting layer 102. Other layers such as an insulating layer 111 and a polarizer layer 112 are disposed on the cathode layer 103 by a chemical vapor deposition method, an inkjet printing method, and the like. A glass cover 113 is bonded by an adhesive glue to complete packaging.

In the fingerprint recognition area 20, the flexible substrate 30, the insulating layer 40, the first gate insulating layer 1012, and the first interlayer dielectric layer 1014 are sequentially stacked. The gate electrode layer 1013 is disposed on the first interlayer dielectric layer 1014. The second gate insulating layer 105 is disposed on the gate electrode layer 1013 and completely covers the gate electrode layer 1013. A second oxide layer 201 is disposed on the second gate insulating layer 105. The second interlayer dielectric layer 107 is disposed on the second oxide layer 201. The flat layer 109 is disposed on the second interlayer dielectric layer 107. The organic light-emitting layer 102 is disposed on the flat layer 109. The cathode layer 103 is disposed on the organic light-emitting layer 102. Other layers such as an insulating layer 111 and a polarizer layer 112 are disposed on the cathode layer 103 by a chemical vapor deposition method, an inkjet printing method, and the like. A glass cover 113 is bonded by an adhesive glue to complete packaging. The flat layer 109, the second interlayer dielectric layer 107, the second oxide layer 201, the second gate insulating layer 105, and the gate electrode layer 1013 constitute the under-screen fingerprint recognition structure 210.

In this embodiment, as shown in FIG. 2, the second oxide layer 201 in the under-screen fingerprint recognition structure 210 is a photosensitive element. Therefore, the second oxide layer 201 is used as an inductive sensor of the under-screen fingerprint recognition structure 210. When light emitted by the organic light-emitting layer 102 is reflected to a sensing area of the second oxide layer 201 by a fingerprint on a screen, the screen can be woken up. As shown in FIG. 2, the low-temperature polycrystalline oxide structure 101 and the under-screen fingerprint recognition structure 210 are disposed on a same layer. The anode layer 104 has a characteristic of totally reflecting light, and the cathode layer 103 has a characteristic of semi-reflecting light.

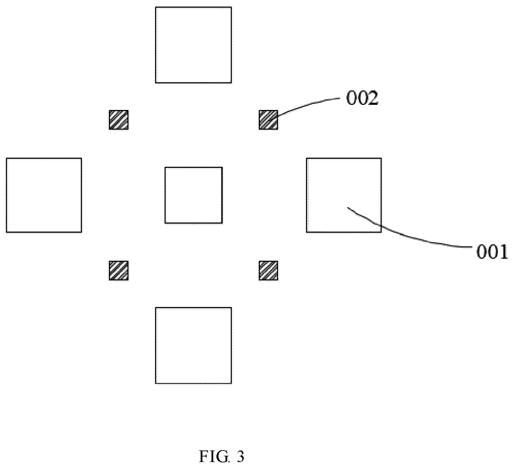

Please refer to FIG. 3, which is a schematic diagram showing relative positions of induction sensors of an under-screen fingerprint recognition structure. As shown in FIG. 3, in a structure of a display substrate, inductive sensors 002 of an under-screen fingerprint recognition structure are disposed in gaps of RGB pixels 001, which can save space and improve response times of fingerprint recognition.

The present invention provides a display substrate combining LTPO technology and under-screen fingerprint recognition technology, in which light emitted by an organic light-emitting layer is reflected by a finger and then sensed by an inductive sensor in an under-screen fingerprint recognition structure to wake up a screen, thereby realizing an induction function of a built-in fingerprint on display. Furthermore, the organic light-emitting layer is not a functional layer in the under-screen fingerprint recognition structure. Therefore, the organic light-emitting layer can be removed from the under-screen fingerprint recognition structure to allow more light reflected by the finger to enter the inductive sensor, thereby greatly improving light-sensing ability. The display substrate manufactured using the LTPO technology can also save screen power.

The display substrates provided by the embodiments of the present disclosure are described in detail above. The present disclosure uses specific examples to describe principles and embodiments of the present application. The above description of the embodiments is only for helping to understand the technical solutions of the present disclosure and its core ideas. It should be understood by those skilled in the art that they can modify the technical solutions recited in the foregoing embodiments, or replace some of technical features in the foregoing embodiments with equivalents. These modifications or replacements do not cause essence of corresponding technical solutions to depart from the scope of the technical solutions of the embodiments of the present disclosure.

## Claims

1. A display substrate (1) comprising:
a display area (10) comprising a low-temperature polycrystalline oxide structure (101), an anode layer (104), an organic light-emitting layer (102), and a cathode layer (103) that are sequentially stacked on a flexible substrate (30) that is a bottommost layer of the display area (10); and
a fingerprint recognition area (20) comprising an under-screen fingerprint recognition structure (210) on the flexible substrate (30), wherein the under-screen fingerprint recognition structure (210) is disposed on a same layer as the low-temperature polycrystalline oxide structure (101) and does not comprise the cathode layer (103) and the organic light-emitting layer (102);
wherein, light emitted from the display area (10) is reflected to the under-screen fingerprint recognition structure (210) in the fingerprint recognition area (20) by a fingerprint;
**characterized in that** the anode layer (104) totally reflects light, and an orthogonal projection of the under-screen fingerprint recognition structure (210) on the flexible substrate (30) is not overlapped with an orthogonal projection of the anode layer (104) on the flexible substrate (30);
the under-screen fingerprint recognition structure (210) comprises a gate electrode (1013) and an oxide (201), and the oxide (201) is a photosensitive element and is used as an inductive sensor (002) of the under-screen fingerprint recognition structure (210);
light emitted by the organic light-emitting layer (102) in the display area (10) is reflected to the oxide (201) of the under-screen fingerprint recognition structure (210);
the cathode layer (103) semi-reflects light.

2. The display substrate (1) as claimed in claim 1, **characterized in that** the inductive sensor (002) of the under-screen fingerprint recognition structure (210) is disposed in a gap of a pixel structure.

3. A display substrate (1) comprising:
a display area (10) comprising a low-temperature polycrystalline oxide structure (101), an anode layer (104), an organic light-emitting layer (102), and a cathode layer (103) that are sequentially stacked on a flexible substrate (30) that is a bottommost layer of the display area (10); and
a fingerprint recognition area (20) comprising an under-screen fingerprint recognition structure (210) on the flexible substrate;
wherein the low-temperature polycrystalline oxide structure (101) and the under-screen fingerprint recognition structure (210) are disposed on a same layer and share the cathode layer (103) and the organic light-emitting layer (102), and light emitted from the display area (10) is reflected to the under-screen fingerprint recognition structure (210) in the fingerprint recognition area (20) by a fingerprint;
**characterized in that** the anode layer (104) totally reflects light, and an orthogonal projection of the under-screen fingerprint recognition structure (210) on the flexible substrate (30) is not overlapped with an orthogonal projection of the anode layer (104) on the flexible substrate (30);
the under-screen fingerprint recognition structure (210) further comprises a gate electrode (1013) and an oxide (201), and the oxide (201) is a photosensitive element and is used as an inductive sensor (002) of the under-screen fingerprint recognition structure (210);
the cathode layer (103) semi-reflects light.

## Patentansprüche

1. Ein Anzeigesubstrat (1), umfassend:
ein Anzeigebereich (10), der eine polykristalline Niedertemperatur-Oxidstruktur (101), eine Anodenschicht (104), eine organische Leuchtschicht (102) und eine Kathodenschicht (103) umfasst, die nacheinander auf einem flexiblen Substrat (30) aufgeschichtet sind, das die unterste Schicht des Anzeigebereichs (10) bildet; und
ein Fingerabdruckerkennungsbereich (20), der eine unter dem Bildschirm angeordnete Fingerabdruckerkennungsstruktur (210) auf dem flexiblen Substrat (30) umfasst, wobei die unter dem Bildschirm angeordnete Fingerabdruckerkennungsstruktur (210) auf derselben Schicht wie die polykristalline Niedertemperatur-Oxidstruktur (101) angeordnet ist und weder die Kathodenschicht (103) noch die organische Leuchtschicht (102) umfasst;
wobei das vom Anzeigebereich (10) emittierte Licht durch einen Fingerabdruck auf die unter dem Bildschirm angeordnete Fingerabdruckerkennungsstruktur (210) im Fingerabdruckerkennungsbereich (20) reflektiert wird;
**dadurch gekennzeichnet, dass** die Anodenschicht (104) Licht vollständig reflektiert und sich eine orthogonale Projektion der unter dem Bildschirm angeordneten Fingerabdruckerkennungsstruktur (210) auf das flexible Substrat (30) nicht mit einer orthogonalen Projektion der Anodenschicht (104) auf das flexible Substrat (30) überschneidet;
die unter dem Bildschirm angeordnete Fingerabdruckerkennungsstruktur (210) eine Gate-Elektrode (1013) und ein Oxid (201) umfasst, wobei das Oxid (201) ein lichtempfindliches Element ist und als induktiver Sensor (002) der unter dem Bildschirm angeordneten Fingerabdruckerkennungsstruktur (210) dient;
das von der organischen Leuchtschicht (102) im Anzeigebereich (10) emittierte Licht zum Oxid (201) der unter dem Bildschirm angeordneten Fingerabdruckerkennungsstruktur (210) reflektiert wird;
die Kathodenschicht (103) reflektiert das Licht teilweise.

2. Ein Anzeigesubstrat (1) nach Anspruch 1, **dadurch gekennzeichnet, dass** der induktive Sensor (002) der unter dem Bildschirm angeordneten Fingerabdruckerkennungsstruktur (210) in einem Zwischenraum einer Pixelstruktur angeordnet ist.

3. Ein Anzeigesubstrat (1), umfassend:
ein Anzeigebereich (10), der eine polykristalline Niedertemperatur-Oxidstruktur (101), eine Anodenschicht (104), eine organische Leuchtschicht (102) und eine Kathodenschicht (103) umfasst, die nacheinander auf einem flexiblen Substrat (30) aufgeschichtet sind, das die unterste Schicht des Anzeigebereichs (10) bildet; und
ein Fingerabdruckerkennungsbereich (20), der eine unter dem Bildschirm angeordnete Fingerabdruckerkennungsstruktur (210) auf dem flexiblen Substrat umfasst;
wobei die polykristalline Niedertemperatur-Oxidstruktur (101) und die unter dem Bildschirm angeordnete Fingerabdruckerkennungsstruktur (210) auf derselben Schicht angeordnet sind und sich die Kathodenschicht (103) sowie die organische Leuchtschicht (102) teilen, und das vom Anzeigebereich (10) emittierte Licht durch einen Fingerabdruck auf die unter dem Bildschirm angeordnete Fingerabdruckerkennungsstruktur (210) im Fingerabdruckerkennungsbereich (20) reflektiert wird;
**dadurch gekennzeichnet, dass** die Anodenschicht (104) Licht vollständig reflektiert und sich eine orthogonale Projektion der unter dem Bildschirm angeordneten Fingerabdruckerkennungsstruktur (210) auf das flexible Substrat (30) nicht mit einer orthogonalen Projektion der Anodenschicht (104) auf das flexible Substrat (30) überschneidet;
die unter dem Bildschirm angeordnete Fingerabdruckerkennungsstruktur (210) ferner eine Gate-Elektrode (1013) und ein Oxid (201) umfasst, wobei das Oxid (201) ein lichtempfindliches Element ist und als induktiver Sensor (002) der unter dem Bildschirm angeordneten Fingerabdruckerkennungsstruktur (210) dient;
die Kathodenschicht (103) das Licht halbreflektiert.

## Revendications

1. Substrat d'affichage (1) comprenant :
une zone d'affichage (10) comprenant une structure en oxyde polycristallin à basse température (101), une couche d'anode (104), une couche organique électroluminescente (102) et une couche de cathode (103), qui sont empilées successivement sur un substrat flexible (30) constituant la couche la plus inférieure de la zone d'affichage (10) ; et
une zone de reconnaissance d'empreintes digitales (20) comprenant une structure de reconnaissance d'empreintes digitales sous l'écran (210) sur le substrat flexible (30), dans laquelle la structure de reconnaissance d'empreintes digitales sous l'écran (210) est disposée sur une même couche que la structure en oxyde polycristallin à basse température (101) et ne comprend pas la couche de cathode (103) ni la couche organique électroluminescente (102) ;
dans lequel la lumière émise par la zone d'affichage (10) est réfléchie vers la structure de reconnaissance d'empreintes digitales sous l'écran (210), située dans la zone de reconnaissance d'empreintes digitales (20), par une empreinte digitale ;
**caractérisé en ce que** la couche d'anode (104) réfléchit totalement la lumière, et **en ce qu'**une projection orthogonale de la structure de reconnaissance d'empreintes digitales sous l'écran (210) sur le substrat flexible (30) ne chevauche pas la projection orthogonale de la couche d'anode (104) sur le substrat flexible (30) ;
la structure de reconnaissance d'empreintes digitales sous l'écran (210) comprend une électrode de grille (1013) et un oxyde (201), et l'oxyde (201) est un élément photosensible et sert de capteur inductif (002) pour la structure de reconnaissance d'empreintes digitales sous l'écran (210) ;
la lumière émise par la couche électroluminescente organique (102) dans la zone d'affichage (10) est réfléchie vers l'oxyde (201) de la structure de reconnaissance d'empreintes digitales sous l'écran (210) ;
la couche de cathode (103) est semi-réfléchissante.

2. Substrat d'affichage (1) selon la revendication 1, **caractérisé en ce que** le capteur inductif (002) de la structure de reconnaissance d'empreintes digitales sous l'écran (210) est disposé dans un interstice d'une structure de pixels.

3. Un substrat d'affichage (1) comprenant :
une zone d'affichage (10) comprenant une structure en oxyde polycristallin à basse température (101), une couche d'anode (104), une couche organique électroluminescente (102) et une couche de cathode (103), qui sont empilées successivement sur un substrat flexible (30) constituant la couche la plus inférieure de la zone d'affichage (10) ; et
une zone de reconnaissance d'empreintes digitales (20) comprenant une structure de reconnaissance d'empreintes digitales sous l'écran (210) sur le substrat flexible ;
dans lequel la structure en oxyde polycristallin à basse température (101) et la structure de reconnaissance d'empreintes digitales sous l'écran (210) sont disposées sur une même couche et partagent la couche de cathode (103) et la couche organique électroluminescente (102), et la lumière émise par la zone d'affichage (10) est réfléchie vers la structure de reconnaissance d'empreintes digitales sous l'écran (210) dans la zone de reconnaissance d'empreintes digitales (20) par une empreinte digitale ;
**caractérisé en ce que** la couche d'anode (104) réfléchit totalement la lumière, et **en ce qu'**une projection orthogonale de la structure de reconnaissance d'empreintes digitales sous l'écran (210) sur le substrat flexible (30) ne chevauche pas la projection orthogonale de la couche d'anode (104) sur le substrat flexible (30) ;
la structure de reconnaissance d'empreintes digitales sous l'écran (210) comprend en outre une électrode de grille (1013) et un oxyde (201), et l'oxyde (201) est un élément photosensible et sert de capteur inductif (002) de la structure de reconnaissance d'empreintes digitales sous l'écran (210) ;
la couche de cathode (103) est semi-réfléchissante.
